# FASCICULE DE BREVET EUROPEEN

(11) **EP 1 949 408 B1**
(45) Date de publication et mention de la délivrance du brevet: **25.11.2009**
(21) Numéro de dépôt: 06831027.5
(22) Date de dépôt: 26.10.2006
(51) Int. Cl.: H01J 37/34, C23C 14/02

(54) **PROCEDE ET INSTALLATION D'AVIVAGE SOUS VIDE PAR PULVERISATION MAGNETRON D'UNE BANDE METALLIQUE**
VERFAHREN UND VORRICHTUNG ZUR FÄRBUNG EINES METALLSTREIFENS IM VAKUUM MITTELS MAGNETRON-SPUTTERN
METHOD AND DEVICE FOR COLOURING A METAL STRIP IN VACUUM BY MAGNETRON SPUTTERING

(30) Priorité: 07.11.2005 EP 05292354
(43) Date de publication de la demande: 30.07.2008
(73) Titulaire: ArcelorMittal France, 93200 Saint Denis (FR)
(72) Inventeur: CORNIL, Hugues, B-4570 Marchin (BE); DEWEER, Benoît, B-1933 Sterrebeek (BE); MABOGE, Claude, B-5650 Castillon (BE); MOTTOULLE, Jacques, B-5020 Namur (Malonne) (BE)
(74) Mandataire: Plaisant, Sophie Marie
(86) Numéro de dépôt international: PCT/FR2006/002414
(87) Numéro de publication internationale: WO 2007/051916

(56) Documents cités:
- EP-A- 0 878 565
- WO-A-98/26108
- PATENT ABSTRACTS OF JAPAN vol. 1997, no. 09, 30 septembre 1997 (1997-09-30) -& JP 09 125247 A (SONY CORP), 13 mai 1997 (1997-05-13)

## Description

La présente invention concerne un procédé et une installation d'avivage sous vide par pulvérisation magnétron d'une bande métallique, telle qu'une bande d'acier, par exemple.

Lors des opérations de revêtement sous vide d'une bande d'acier, l'état de propreté de la bande avant dépôt est l'un des facteurs clés de réussite, car il détermine la bonne adhérence du revêtement à déposer. Un des procédés utilisés pour ce faire est l'avivage sous vide par pulvérisation magnétron encore appelé etching. Ce procédé consiste à créer un plasma entre la bande et une contre-électrode, dans un gaz permettant de générer des radicaux et/ou ions. Ces ions vont, dans les conditions normales de fonctionnement, être accélérés vers la surface de la bande à décaper, et venir arracher des atomes superficiels, nettoyant ainsi la surface éventuellement souillée, tout en l'activant.

La bande à décaper se déplace dans une chambre sous vide en regard d'une contre-électrode. Cette dernière est polarisée positivement par rapport au substrat, lui-même préférentiellement relié à la masse. Un ensemble d'aimants positionné à l'arrière de la bande confine le plasma créé auprès de celle-ci. Afin de positionner de façon très précise la bande métallique à traiter, par rapport à la contre-électrode nécessaire à la mise en oeuvre de la pulvérisation magnétron, la bande métallique est généralement disposée sur un rouleau d'appui qui peut être mis en rotation autour de son axe.

La mise en oeuvre à l'échelle industrielle de ce type de traitement de surface impose des contraintes supplémentaires au procédé. Il est en particulier nécessaire de pouvoir adapter la largeur de la surface avivée à la largeur de la bande d'acier, qui peut varier au cours du temps. Une telle adaptation impose de limiter l'action des radicaux ou ions générés dans le plasma à la zone délimitée par la bande métallique à décaper.

A cet effet, on connaît le brevet EP-A-0 603 587 décrivant une installation permettant d'éroder un substrat de manière homogène à l'aide d'un plasma. Cette installation permet de déplacer la zone d'avivage sur de faibles longueurs sans pour autant changer sa dimension dans une quelconque direction. Celle-ci rend l'érosion du substrat plus uniforme, mais ne permet pas de s'adapter réellement à une variation de largeur de la bande à traiter.

On connaît également EP-A-0 878 565 qui décrit plusieurs installations visant à résoudre ce problème de la variation de largeur d'un substrat à traiter par etching. Un premier dispositif représenté en figure 4 et 5, met en oeuvre un circuit magnétique composé de trois circuits unitaires de même largeur. Le circuit central est fixe et les deux autres peuvent se déplacer latéralement par rapport à la bande pour adapter la largeur du circuit magnétique total à la largeur de la bande. Lorsque la bande n'est pas positionnée sur un rouleau ou repose sur un rouleau non conducteur, il est difficile d'allumer un race track s'étendant partiellement sur la bande et partiellement sur une surface isolante. En effet, les rives tendent à créer un champ électrique non uniforme (effet de pointe), et un race track entrecoupé à ce niveau entraîne l'apparition de nombreux arcs lorsque l'on souhaite monter en puissance. Le dispositif fonctionne donc uniquement lorsque les circuits magnétiques latéraux ne se trouvent pas en regard de la bande d'acier ou se trouvent totalement en regard de celle-ci. Dans ce dernier cas cependant, l'avivage n'est pas uniforme car les surfaces d'action des circuits magnétiques se chevauchent afin de s'adapter à la largeur de la bande.

Lorsque la bande est positionnée sur un rouleau conducteur, le dispositif ne peut fonctionner sans l'éroder de façon continue et importante, entraînant des remplacements fréquents.

Ce document décrit un second dispositif, représenté aux figures 1 à 3, mettant en oeuvre un circuit magnétique constitué d'aimants permanents en forme de cadre rectangulaire 3 (pôle nord) et d'aimants permanents formés de trois barreaux parallèles successifs 4 (pôle sud), ou inversement. Le barreau central 4a du pôle sud comme les cotés longitudinaux 3a du cadre 3 formant le pôle nord sont fixes. Les cotés d'extrémité 3b du cadre 3 et les barreaux 4b du pôle sud peuvent coulisser ensemble dans le sens transversal par rapport au sens de déplacement de la bande. Lorsque la bande n'est pas positionnée sur un rouleau ou repose sur un rouleau non conducteur, un problème se pose de nouveau au niveau des rives. Des arcs apparaissent lorsque le circuit magnétique dépasse légèrement du bord de bande afin d'aviver correctement cette partie. De plus, l'avivage est inhomogène lorsque les surfaces d'action des aimants 4 se chevauchent afin de s'adapter à largeur de la bande.

Par contre, lorsque la bande est positionnée sur un rouleau conducteur, l'avivage est toujours non uniforme lorsque les surfaces d'action des aimants 4 se chevauchent. En outre, lorsque la bande est étroite, les aimants nord 3a non en regard de la surface à traiter perturbent également le champ magnétique.

Ce document divulgue également un troisième dispositif, représenté en figure 6, mettant en oeuvre un circuit magnétique de structure multicellulaire. Cette structure est constituée d'une succession de circuits magnétiques indépendants 2', 2",.., s'étendant en rangées successives 12, 12'. Si la bande n'est pas positionnée sur un rouleau cylindrique ou repose sur un rouleau non conducteur, l'installation fonctionne mais entraîne la formation d'arcs au niveau des circuits magnétiques coupant le bord de bande. Si la bande est positionnée sur un rouleau conducteur, l'installation ne permet plus d'adapter la largeur avivée à différentes largeurs de substrat.

La présente invention a donc pour but de remédier aux inconvénients de procédés de l'art antérieur en mettant à disposition un procédé et une installation d'avivage sous vide par sputtering magnétron de la surface d'une bande métallique en défilement sur un rouleau d'appui, qui permette d'adapter le traitement à une variation de la largeur de la bande, tout en traitant la totalité de la surface de façon uniforme et sans détériorer le rouleau d'appui.

A cet effet, l'invention a pour premier objet un procédé d'avivage sous vide par pulvérisation magnétron dans une enceinte sous vide d'une bande métallique défilant sur un rouleau d'appui en regard d'une contre-électrode, dans lequel on crée un plasma dans un gaz à proximité de ladite bande métallique, de manière à générer des radicaux et/ou des ions agissant sur cette bande, **caractérisé en ce que** l'on sélectionne au moins un circuit magnétique fermé dont la largeur est sensiblement égale à celle de ladite bande métallique, parmi une série d'au moins deux circuits magnétiques fermés de largeurs différentes et fixes, lesdits circuits magnétiques (7) étant positionnés sur un support (6) placé à l'intérieur dudit rouleau d'appui (3), puis que l'on achemine ledit circuit magnétique sélectionné pour le positionner en regard de ladite bande métallique, puis que l'on procède à l'avivage de ladite bande métallique en mouvement.

Le procédé selon l'invention peut en outre incorporer les caractéristiques suivantes, prises isolément ou en combinaison :
- le rouleau d'appui est un rouleau conducteur.
- le ou les circuits magnétiques fermés comprennent des rangées d'aimants disposés bord à bord, deux rangées successives présentant des polarités opposées,
- le ou les circuits magnétiques sélectionnés génèrent un champ magnétique tangent à la bande métallique d'une intensité supérieure à 0,03T,
- le ou les circuits magnétiques sont disposés sur la surface extérieure d'un support cylindrique placé à l'intérieur du rouleau d'appui de manière concentrique par rapport au rouleau, le support cylindrique étant mobile en rotation autour de son axe,
- le ou les circuits magnétiques sont placés sur une culasse en acier doux,
- le ou les circuits magnétiques sont ordonnés par taille croissante à la surface du support cylindrique,
- les circuits magnétiques non sélectionnés sont occultés par un dispositif de neutralisation ne laissant pas passer un champ magnétique de plus de 0,01 T desdits circuits magnétiques vers la bande métallique,
- le dispositif de neutralisation est en deux parties positionnées de part et d'autre dudit ou desdits circuits magnétiques, définissant une fenêtre d'avivage,
- on traite une première bobine de bande métallique présentant une largeur constante L1 puis une seconde bobine de largeur constante L2, la première bobine étant traitée au moyen d'un circuit magnétique fermé de largeur L1 que l'on amène au-dessus de ladite bande, puis l'on retire ledit circuit pour le remplacer par un second circuit de largeur L2 avec lequel on traite ladite seconde bobine de bande métallique présentant une largeur constante L2,
- la bande métallique avivée est ensuite revêtue sous vide par un revêtement de protection,
- la bande métallique est une bande en acier.

Un second objet de l'invention est constitué par une installation d'avivage sous vide par pulvérisation magnétron d'une bande métallique comprenant un rouleau d'appui en regard d'une contre-électrode, des moyens de polarisation de ladite bande métallique, des moyens permettant de créer un plasma dans un gaz entre ladite bande et ladite contre-électrode, une série d'au moins deux circuits magnétiques fermés de largeurs différentes et fixes, susceptibles chacun de traiter seul l'intégralité de la largeur d'une bande métallique, lesdits circuits magnétiques (7) étant positionnés sur un support (6) placé à l'intérieur dudit rouleau d'appui (3), et des moyens d'acheminement d'un ou plusieurs desdits circuits magnétiques en regard de ladite bande métallique.

L'installation selon l'invention peut en outre incorporer les caractéristiques suivantes, prises isolément ou en combinaison :
- le rouleau d'appui est un rouleau conducteur,
- le ou les circuits magnétiques fermés comprennent des rangées d'aimants disposés bord à bord, deux rangées successives présentant des polarités opposées,
- le ou les circuits magnétiques peuvent générer un champ magnétique tangent à la bande métallique d'une intensité supérieure à 0,03 T
- le ou les circuits magnétiques sont disposés sur la surface extérieure d'un support cylindrique placé à l'intérieur du rouleau d'appui de manière concentrique par rapport au rouleau, le support cylindrique étant mobile en rotation autour de son axe,
- le ou les circuits magnétiques sont placés sur une culasse en acier doux,
- le ou les circuits magnétiques sont ordonnés par taille croissante à la surface du support cylindrique,
- l'installation comprend en outre un dispositif de neutralisation ne laissant pas passer un champ magnétique de plus de 0,01 T des circuits magnétiques vers la bande métallique,
- l'installation de neutralisation est en deux parties pouvant être positionnées de part et d'autre dudit ou desdits circuits magnétiques, entre la bande métallique et la contre-électrode.

L'invention va à présent être décrite plus en détail en référence aux figures annexées qui représentent :
- figure 1 : vue schématique en coupe d'un mode de réalisation d'une installation selon l'invention,
- figure 2 : vue schématique de dessus d'une partie de l'installation de la figure 1.

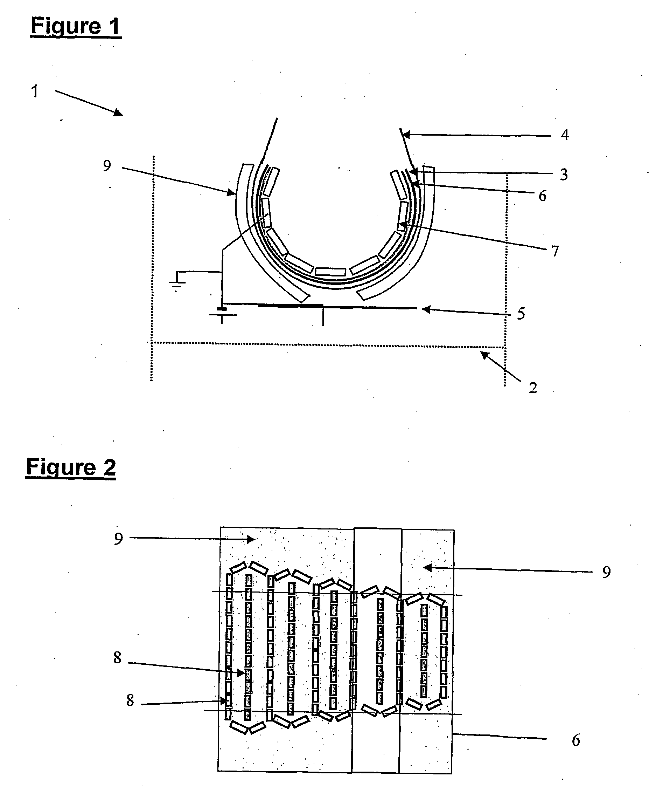

Si l'on considère tout d'abord la figure 1, on peut y voir une installation 1 selon l'invention comprenant une chambre 2 sous vide dans laquelle est monté un rouleau d'appui 3 présentant une surface cylindrique et pouvant tourner autour d'un axe. Une bande d'acier à décaper 4 s'enroule autour de ce rouleau 3 en regard d'une contre-électrode 5. Celle-ci est polarisée positivement par rapport à la bande d'acier, qui est-elle préférentiellement reliée à la masse.

Le système de contre-électrode peut-être constitué d'une ou plusieurs électrodes et peut prendre différentes formes, telle qu'un fil par exemple.

A l'intérieur du rouleau 3 est monté un support en forme de tambour 6 qui accueille en son sein un certain nombre de circuits magnétiques 7. Le rouleau d'appui 3 doit être de diamètre suffisant pour accueillir en son sein le nombre adéquat de pistes magnétiques 7 permettant de s'adapter à l'ensemble des largeurs prévues dans la gamme de fabrication.

Le rouleau 3 étant continuellement érodé par le plasma qui dépasse des rives de la bande 4, la table de celui-ci doit donc être considérée comme une pièce d'usure. Le rouleau 3 doit être facilement rectifiable et la table facilement remplaçable en fin de vie. Cette durée de vie dépend de la vitesse de pulvérisation de la surface. Le choix d'un éventuel revêtement conducteur ayant une vitesse d'érosion plus faible peut être fait pour améliorer sa durée de vie.

Le rouleau 3 peut éventuellement être relié à la terre et est de préférence conducteur. En effet, ce mode de réalisation permet de limiter, voire d'éviter l'apparition d'arcs sur les rives de la bande lors de l'avivage, ce qui pourrait rendre le traitement non uniforme entre le centre de la bande et ses rives.

Le tambour 6 peut être mis en rotation en cours de production à l'intérieur du rouleau d'appui 3. Ce tambour 6 doit être de diamètre suffisant pour accueillir le nombre adéquat de pistes magnétiques 7 permettant de s'adapter à l'ensemble des largeurs prévues dans la gamme de fabrication.

Comme on peut le voir en figure 2, les circuits magnétiques 7 sont de largeur différente et croissante dans la direction transversale à la direction de déplacement de la bande d'acier 4.

Chaque circuit magnétique 7 est constitué d'aimants 8 pouvant être montés sur des pièces en acier doux. Celles-ci peuvent être soit des éléments indépendants rapportés sur le tambour, soit une virole servant de berceau.

Avantageusement, une culasse en acier doux sous les aimants 8 permet de renforcer le champ induit au-dessus du montage magnétron, et évite aux lignes de champ de se perdre loin à l'arrière des aimants 8.

Les aimants 8 sont disposés de manière à former au moins une piste magnétique fermée où le champ tangeant à la bande est supérieur à 0,03 T et de préférence supérieur à 0,05 T.

Les aimants 8 d'une même rangée sont de préférence disposés bord à bord afin d'éviter des distorsions en créneau du champ qui réduisent l'efficacité du confinement.

Par ailleurs, comme on peut le voir en figure 1, des caches de neutralisation 9 entourent la totalité du rouleau d'appui 3, excepté la partie active dans la fenêtre d'avivage. Les caches 9 peuvent être réalisés en matériau non ferromagnétique, et peuvent être en volume plein ou encore creux mais fermés. L'épaisseur de ces caches 9 est telle que le champ magnétique sortant de ceux-ci est inférieur à 0,01 T et avantageusement inférieur à 0,005 T, de manière à éviter l'allumage d'un plasma en dehors de la zone d'avivage.

Le fonctionnement du dispositif selon l'invention va à présent être décrit. Lorsque l'on souhaite décaper la bande métallique 4, qui peut être en acier, en aluminium, en cuivre, etc, on la polarise, par exemple négativement, et on la fait défiler dans l'enceinte sous vide 2. Un plasma est allumé dans cette enceinte 2 entre la contre-électrode, polarisée positivement, et la bande 4. Le bombardement d'ions et/ou de radicaux sur la bande 4 permet de l'aviver.

Par rotation du tambour 6, le ou les circuits magnétiques 7 de largeur désirée sont sélectionnés et positionnés en regard de la contre-électrode 5. Les caches de neutralisation du champ magnétique 9, sont positionnés de part et d'autre du ou des circuits magnétiques 7, afin de régler la fenêtre d'avivage aux dimensions exactes de la bande 4 en défilement. Lorsque la bande 4 change de largeur, il suffit de faire tourner le tambour 6 jusqu'à positionner le circuit magnétique 7 de largeur adaptée en face de la contre-électrode.

On voit donc que le dispositif et le procédé selon l'invention permettent de traiter une bande métallique de largeur variable de façon efficace et simple, en la traitant de façon uniforme sur l'ensemble de sa surface y compris les rives, sans générer d'arcs électriques et sans détériorer le rouleau d'appui qui ne subit pas d'avivage.

Par ailleurs, on peut également utiliser le dispositif selon l'invention pour traiter des bobines successive de bandes métalliques de largeur constante mais différente, les unes à la suite des autres. Ainsi, si on doit traiter une première bobine de bande de largeur constante L1, puis une seconde bobine de bande de largeur constante L2, on positionne tout d'abord un premier circuit magnétique 7 de largeur L1 au-dessus de la bande 4 et on traite l'intégralité de la première bobine sans modifier l'installation. On fait ensuite tourner le tambour 6 de telle sorte qu'un second circuit magnétique 7 de largeur L2 soit en face du trajet de la bande 4 et on traite la seconde bobine de largeur L2, après avoir positionné les caches 9 pour neutraliser les autres circuits 7 non sélectionnés. En fonction de la gamme de fabrication de la ligne industrielle, on peut ainsi prévoir avantageusement un tambour 6 muni d'autant de circuits magnétiques 7 qu'il y a de largeurs de bandes dans cette gamme de fabrication.

## Revendications

1. Procédé d'avivage sous vide par pulvérisation magnétron dans une enceinte sous vide (2) d'une bande métallique (4) défilant sur un rouleau d'appui (3) en regard d'une contre-électrode (5), dans lequel on crée un plasma dans un gaz à proximité de ladite bande métallique (4), de manière à générer des radicaux et/ou des ions agissant sur cette bande (4), **caractérisé en ce que** l'on sélectionne au moins un circuit magnétique fermé (7) dont la largeur est sensiblement égale à celle de ladite bande métallique (4), parmi une série d'au moins deux circuits magnétiques fermés (7) de largeurs différentes et fixes, lesdits circuits magnétiques (7) étant positionnés sur un support (6) placé à l'intérieur dudit rouleau d'appui (3), puis que l'on achemine ledit circuit magnétique (7) sélectionné pour le positionner en regard de ladite bande métallique (4), puis que l'on procède à l'avivage de ladite bande métallique (4) en mouvement.

2. Procédé selon la revendication 1, dans lequel ledit rouleau d'appui (3) est un rouleau conducteur.

3. Procédé selon l'une quelconque des revendications 1 ou 2, dans lequel ledit ou lesdits circuits magnétiques fermés (7) comprennent des rangées d'aimants (8) disposés bord à bord, deux rangées successives présentant des polarités opposées.

4. Procédé selon l'une quelconque des revendications 1 à 3, dans lequel ledit ou lesdits circuits magnétiques (7) sélectionnés génèrent un champ magnétique tangent à ladite bande métallique (4) d'une intensité supérieure à 0,03 T.

5. Procédé selon l'une quelconque des revendications 1 à 4, dans lequel ledit ou lesdits circuits magnétiques (7) sont disposés sur la surface extérieure dudit support cylindrique (6) de manière concentrique par rapport audit rouleau (3), le support cylindrique (6) étant mobile en rotation autour de son axe.

6. Procédé selon l'une quelconque des revendications 1 à 5, dans lequel ledit ou lesdits circuits magnétiques (7) sont placés sur une culasse en acier doux.

7. Procédé selon l'une quelconque des revendications 5 ou 6, dans lequel ledit ou lesdits circuits magnétiques (7) sont ordonnés par taille croissante à la surface dudit support cylindrique (6).

8. Procédé selon l'une quelconque des revendications 1 à 7, dans lequel les circuits magnétiques (7) non sélectionnés sont occultés par un dispositif de neutralisation (9) ne laissant pas passer un champ magnétique de plus de 0,01 T desdits circuits magnétiques (7) vers la bande métallique (4).

9. Procédé selon la revendication 8, dans lequel ledit dispositif de neutralisation (9) est en deux parties positionnées de part et d'autre dudit ou desdits circuits magnétiques (7), définissant une fenêtre d'avivage.

10. Procédé selon l'une quelconque des revendications 1 à 9, dans lequel on traite une première bobine de bande métallique (4) présentant une largeur constante L1 puis une seconde bobine de largeur constante L2, la première bobine étant traitée au moyen d'un circuit magnétique fermé (7) de largeur L1 que l'on amène au-dessus de ladite bande (4), puis l'on retire ledit circuit (7) pour le remplacer par un second circuit (7) de largeur L2 avec lequel on traite ladite seconde bobine de bande métallique (4) présentant une largeur constante L2.

11. Procédé selon l'une quelconque des revendications 1 à 10, dans lequel la bande métallique (4) est une bande en acier.

12. Procédé selon l'une quelconque des revendications 1 à 11, dans lequel ladite bande métallique (4) avivée est ensuite revêtue sous vide par un revêtement de protection.

13. Installation d'avivage sous vide par pulvérisation magnétron (1) d'une bande métallique (4) comprenant un rouleau d'appui (3) en regard d'une contre-électrode (5), des moyens de polarisation de ladite bande métallique (4), des moyens permettant de créer un plasma dans un gaz entre ladite bande (4) et ladite contre-électrode (5), **caractérisé en ce que** l'installation comprend une série d'au moins deux circuits magnétiques fermés (7) de largeurs différentes et fixes, susceptibles chacun de traiter seul l'intégralité de la largeur d'une bande métallique (4), lesdits circuits magnétiques (7) étant positionnés sur un support (6) placé à l'intérieur dudit rouleau d'appui (3), et des moyens d'acheminement d'un ou plusieurs desdits circuits magnétiques (7) en regard de ladite bande métallique (4).

14. Installation selon la revendication 13, dans laquelle ledit rouleau d'appui (3) est un rouleau conducteur.

15. Installation selon l'une quelconque des revendications 13 ou 14, dans laquelle ledit ou lesdits circuits magnétiques fermés (7) comprennent des rangées d'aimants (8) disposés bord à bord, deux rangées successives présentant des polarités opposées.

16. Installation selon l'une quelconque des revendications 13 à 15, dans laquelle ledit ou lesdits circuits magnétiques (7) peuvent générer un champ magnétique tangent à ladite bande métallique (4) d'une intensité supérieure à 0,03 T.

17. Installation selon l'une quelconque des revendications 13 à 16, dans laquelle ledit ou lesdits circuits magnétiques (7) sont disposés sur la surface extérieure dudit support cylindrique (6) de manière concentrique par rapport audit rouleau (3), le support cylindrique (6) étant mobile en rotation autour de son axe.

18. Installation selon l'une quelconque des revendications 13 à 17, dans laquelle ledit ou lesdits circuits magnétiques (7) sont placés sur une culasse en acier doux.

19. Installation selon l'une quelconque des revendications 17 ou 18, dans laquelle ledit ou lesdits circuits magnétiques (7) sont ordonnés par taille croissante à la surface dudit support cylindrique (6).

20. Installation selon l'une quelconque des revendications 13 à 19, comprenant en outre un dispositif de neutralisation (9) ne laissant pas passer un champ magnétique de plus de 0,01 T desdits circuits magnétiques (7) vers la bande métallique (4).

21. Installation selon la revendication 20, dans lequel ledit dispositif de neutralisation (9) est en deux parties pouvant être positionnées de part et d'autre dudit ou desdits circuits magnétiques (7), entre ladite bande métallique (4) et la contre-électrode (5).

## Claims

1. Vacuum process for etching a metal strip (4) running over a backing roll (3) facing a counterelectrode (5) by magnetron sputtering in a vacuum chamber (2), in which a plasma is created in a gas close to said metal strip (4) so as to generate radicals and/or ions that act on this strip (4), **characterized in that** at least one closed magnetic circuit (7), the width of which is approximately equal to that of said metal strip (4), is selected from a series of at least two closed magnetic circuits (7) of different and fixed widths, said magnetic circuits (7) being positioned on a support (6) placed inside said backing roll (3), then said selected magnetic circuit (7) is positioned so as to face said metal strip (4) and then the etching of said moving metal strip (4) is carried out.

2. Process according to Claim 1, in which said backing roll (3) is a conducting roll.

3. Process according to either of Claims 1 and 2, in which said closed magnetic circuit or circuits (7) comprise rows of magnets (8) arranged edge to edge, two successive rows having opposed polarities.

4. Process according to any one of Claims 1 to 3, in which said selected magnetic circuit or circuits (7) generate a magnetic field tangential to said metal strip (4) with an intensity greater than 0.03 T.

5. Process according to any one of Claims 1 to 4, in which said magnetic circuit or circuits (7) are placed on the outer surface of said cylindrical support (6) concentrically with respect to said roll (3), the cylindrical support (6) being able to rotate about this axis.

6. Process according to any one of Claims 1 to 5, in which said magnetic circuit or circuits (7) are placed on a yoke made of mild steel.

7. Process according to any one of Claims 5 and 6, in which said magnetic circuit or circuits (7) are ordered in increasing size toward the surface of said cylindrical support (6).

8. Process according to any one of Claims 1 to 7, in which the magnetic circuits (7) that are not selected are blanked off by a neutralizing device (9) that does not let a magnetic field of greater than 0.01 T pass from said magnetic circuits (7) to the metal strip (4).

9. Process according to Claim 8, in which said neutralizing device (9) is made in two parts that are positioned on either side of said magnetic circuit or circuits (7), defining an etching window.

10. Process according to any one of Claims 1 to 9, in which a first coil of metal strip (4) having a constant width L1 and then a second coil of constant width L2 are treated, the first coil being treated by means of a closed magnetic circuit (7) of width L1 which is brought above said strip (4), and then said circuit (7) is removed so as to replace it by a second circuit (7) of width L2 with which said second coil of metal strip (4) having a constant width L2 is treated.

11. Process according to any one of Claims 1 to 10, in which the metal strip (4) is a steel strip.

12. Process according to any one of Claims 1 to 11, in which said etched metal strip (4) is then vacuum-coated with a protective coating.

13. Vacuum installation (1) for etching a metal strip (4) by magnetron sputtering, comprising a backing roll (3) facing a counterelectrode (5), means for biasing said metal strip (4), means for creating a plasma in a gas between said strip (4) and said counterelectrode (5), **characterized in that** the installation comprises a series of at least two closed magnetic circuits (7) of different fixed widths, each capable of individually treating the entire width of a metal strip (4), said magnetic circuits (7) being positioned on a support (6) placed inside said backing roll (3), and means for positioning one or more of said magnetic circuits (7) facing said metal strip (4).

14. Installation according to Claim 13, in which said backing roll (3) is a conducting roll.

15. Installation according to either of Claims 13 and 14, in which said closed magnetic circuit or circuits (7) comprise rows of magnets (8) arranged edge to edge, two successive rows having opposed polarities.

16. Installation according to any one of Claims 13 to 15, in which said magnetic circuit or circuits (7) may generate a magnetic field tangential to said metal strip (4) with an intensity greater than 0.03 T.

17. Installation according to any one of Claims 13 to 16, in which said magnetic circuit or circuits (7) are placed on the outer surface of said cylindrical support (6) concentrically with respect to said roll (3), the cylindrical support (6) being able to rotate about this axis.

18. Installation according to any one of Claims 13 to 17, in which said magnetic circuit or circuits (7) are placed on a yoke made of mild steel.

19. Installation according to either of Claims 17 and 18, in which said magnetic circuit or circuits (7) are ordered in increasing size toward the surface of said cylindrical support (6).

20. Installation according to any one of Claims 13 to 19 which further includes a neutralizing device (9) that does not let a magnetic field of greater than 0.01 T pass from said magnetic circuits (7) to the metal strip (4).

21. Installation according to Claim 20, in which said neutralizing device (9) is made in two parts that can be positioned on either side of said magnetic circuit or circuits (7), between said metal strip (4) and the counterelectrode (5).

## Patentansprüche

1. Verfahren zum Anätzen im Vakuum durch Magnetron-Zerstäubung in einem Vakuumbehälter (2) eines Metallbandes (4), das sich auf einer Abstützrolle (3) gegenüber einer Gegenelektrode (5) vorbeibewegt, wobei in einem Gas in der Umgebung des Metallbandes (4) ein Plasma erzeugt wird, derart, dass Radikale und/oder Ionen erzeugt werden, die auf dieses Band (4) einwirken, **dadurch gekennzeichnet, dass** aus einer Reihe von wenigstens zwei geschlossenen Magnetkreisen (7) mit unterschiedlichen und festen Breiten wenigstens ein geschlossener Magnetkreis (7), dessen Breite im Wesentlichen gleich jener des Metallbandes (4) ist, gewählt wird, wobei die Magnetkreise (7) auf einem Träger (6) positioniert sind, der in der Abstützrolle (3) angeordnet ist, dass dann der gewählte Magnetkreis (7) transportiert wird, um ihn gegenüber dem Metallband (4) zu positionieren, und dass dann das Anätzen des in Bewegung befindlichen Metallbandes (4) ausgeführt wird.

2. Verfahren nach Anspruch 1, wobei die Abstützrolle (3) eine Leiterrolle ist.

3. Verfahren nach einem der Ansprüche 1 oder 2, wobei der oder die geschlossenen Magnetkreise (7) Reihen von Magneten (8) enthalten, die Kante an Kante angeordnet sind, wobei zwei aufeinander folgende Reihen entgegengesetzte Polaritäten aufweisen.

4. Verfahren nach einem der Ansprüche 1 bis 3, wobei der oder die ausgewählten Magnetkreise (7) ein zu dem Metallband (4) tangentiales Magnetfeld mit einer Stärke von mehr als 0,03 T erzeugen.

5. Verfahren nach einem der Ansprüche 1 bis 4, wobei der oder die Magnetkreise (7) auf der äußeren Oberfläche des zylindrischen Trägers (6) konzentrisch in Bezug auf die Rolle (3) angeordnet sind, wobei der zylindrische Träger (6) rotatorisch um seine Achse beweglich ist.

6. Verfahren nach einem der Ansprüche 1 bis 5, wobei der oder die Magnetkreise (7) auf einem Magnetjoch aus Weichstahl angeordnet sind.

7. Verfahren nach einem der Ansprüche 5 oder 6, wobei der oder die Magnetkreise (7) auf der Oberfläche des zylindrischen Trägers (6) nach wachsender Größe geordnet sind.

8. Verfahren nach einem der Ansprüche 1 bis 7, wobei die Magnetkreise (7), die nicht gewählt sind, durch eine Neutralisierungsvorrichtung (9) abgedeckt sind, die kein Magnetfeld von mehr als 0,01 T der Magnetkreise (7) zu dem Metallband (4) durchlässt.

9. Verfahren nach Anspruch 8, wobei die Neutralisierungsvorrichtung (9) aus zwei Teilen besteht, die beiderseits des oder der Magnetkreise (7) positioniert sind und ein Anätzungsfenster definieren.

10. Verfahren nach einem der Ansprüche 1 bis 9, wobei ein erster Bandring des Metallbandes (4), der eine konstante Breite L1 aufweist, behandelt wird, dann ein zweiter Bandring mit konstanter Breite L2 behandelt wird, wobei der erste Bandring mittels eines geschlossenen Magnetkreises (7) mit Breite L1 behandelt wird, der über das Band (4) geführt worden ist, dass dann der Magnetkreis (7) zurückgezogen wird, um ihn durch einen zweiten Kreis (7) mit Breite L2 zu ersetzen, mit dem der zweite Bandring des Metallbandes (4) behandelt wird, der eine konstante Breite L2 aufweist.

11. Verfahren nach einem der Ansprüche 1 bis 10, wobei das Metallband (4) ein Stahlband ist.

12. Verfahren nach einem der Ansprüche 1 bis 11, wobei das angeätzte Metallband (4) anschließend im Vakuum mit einer Schutzbeschichtung überzogen wird.

13. Anlage zum Anätzen im Vakuum durch Magnetron-Zerstäubung (1) eines Metallbandes (4), mit einer Abstützrolle (3) gegenüber einer Gegenelektrode (5), Mitteln zum Polarisieren des Metallbandes (4) und Mitteln, die ermöglichen, in einem Gas zwischen dem Band (4) und der Gegenelektrode (5) ein Plasma zu erzeugen, **dadurch gekennzeichnet, dass** die Anlage eine Reihe aus wenigstens zwei geschlossenen Magnetkreisen (7) mit unterschiedlichen und festen Breiten, die jeweils nur die gesamte Breite eines Metallbandes (4) behandeln können, wobei die Magnetkreise (7) auf einem Träger (6) positioniert sind, der in der Abstützrolle (3) angeordnet ist, und Mittel zum Transportieren eines oder mehrerer der Magnetkreise (7) an eine Position gegenüber dem Metallband (4) enthält.

14. Anlage nach Anspruch 13, wobei die Abstützrolle (3) eine Leiterrolle ist.

15. Anlage nach einem der Ansprüche 13 oder 14, wobei der oder die geschlossenen Magnetkreise (7) Reihen von Magneten (8) enthalten, die Kante an Kante angeordnet sind, wobei zwei aufeinander folgende Reihen entgegengesetzte Polaritäten aufweisen.

16. Anlage nach einem der Ansprüche 13 bis 15, wobei der oder die Magnetkreise (7) ein zu dem Metallband (4) tangentiales Magnetfeld mit einer Stärke von mehr als 0,03 T erzeugen können.

17. Anlage nach einem der Ansprüche 13 bis 16, wobei der oder die Magnetkreise (7) auf der äußeren Oberfläche des zylindrischen Trägers (6) konzentrisch in Bezug auf die Rolle (3) angeordnet sind, wobei der zylindrische Träger (6) rotatorisch um seine Achse beweglich ist.

18. Anlage nach einem der Ansprüche 13 bis 17, wobei der oder die Magnetkreise (7) auf einem Magnetjoch aus Weichstahl angeordnet sind.

19. Anlage nach einem der Ansprüche 17 oder 18, wobei der oder die Magnetkreise (7) auf der Oberfläche des zylindrischen Trägers (6) nach zunehmender Größe geordnet sind.

20. Anlage nach einem der Ansprüche 13 bis 19, die außerdem eine Neutralisierungsvorrichtung (9) enthält, die kein Magnetfeld von mehr als 0,01 T der Magnetkreise (7) zu dem Metallband (4) durchlässt.

21. Anlage nach Anspruch 20, wobei die Neutralisierungsvorrichtung (9) aus zwei Teilen besteht, die beiderseits des oder der Magnetkreise (7) zwischen dem Metallband (4) und der Gegenelektrode (5) positioniert werden können.
